# EUROPEAN PATENT APPLICATION

(11) **EP 4 195 298 A1**
(43) Date of publication of application: **14.06.2023**
(21) Application number: 21949393.9
(22) Date of filing: 09.07.2021
(51) Int. Cl.: H01L 31/072

(54) **SOLAR CELL, METHOD FOR MANUFACTURING SOLAR CELL, MULTI-JUNCTION SOLAR CELL, SOLAR CELL MODULE, AND PHOTOVOLTAIC POWER GENERATION SYSTEM**

(71) Applicant: KABUSHIKI KAISHA TOSHIBA, Minato-ku Tokyo 105-0023 (JP); Toshiba Energy Systems & Solutions Corporation, Saiwai-ku Kawasaki-shi Kanagawa 2120013 (JP)
(72) Inventor: NAKAGAWA, Naoyuki, Tokyo 105-0023 (JP); MIZUNO, Yukitami, Tokyo 105-0023 (JP); HONISHI, Yuya, Tokyo 105-0023 (JP); SHIBASAKI, Soichiro, Tokyo 105-0023 (JP); YAMAZAKI, Mutsuki, Tokyo 105-0023 (JP); NISHIDA, Yasutaka, Tokyo 105-0023 (JP); YAMAMOTO, Kazushige, Tokyo 105-0023 (JP)
(74) Representative: Hoffmann Eitle
(86) International application number: PCT/JP2021/026049
(87) International publication number: WO 2023/281761

(57) **Abstract**

Solution to Problem of the present invention provides a solar cell, a method for manufacturing a solar cell, a multi-junction solar cell, a solar cell module, and a photovoltaic power generation system having excellent conversion efficiency.

A solar cell of an embodiment includes a p-electrode, a p-type light-absorbing layer containing a cuprous oxide and/or a complex oxide of cuprous oxides on the p-electrode, an n-type layer on the p-type light-absorbing layer, and an n-electrode, when a first region is a region of the p-type light-absorbing layer from an interface between the p-type light absorbing layer to a depth of 10 nm toward the p-electrode and a second region is a region of the p-type light-absorbing layer from the interface between the p-type light absorbing layer and the n-type layer to a depth of 100 nm toward the p-electrode excluding the first region, a maximum intensity of an intensity profile of a HAADF-STEM image of the first region is 95 % or more and 105 % or less of an average intensity of an intensity profile of a HAADF-STEM of the second region.

## Description

### [Technical Field]

Present invention relates to a solar cell, a method for manufacturing method a solar cell, a multi-junction solar cell, a solar cell module, and a photovoltaic power generation system.

### [Background Art]

One of new solar cells is a solar cell using a cuprous oxide (Cu₂O) for a light-absorbing layer. Cu₂O is a wide-gap semiconductor. Since Cu₂O is a safe and inexpensive material including copper and oxygen abundantly present on the earth, it is expected that a high-efficiency and low-cost solar cell can be realized.

### [Citation List]

### [Patent Literature]

[PTL 1]
WO2019/146119

### [Summary of Invention]

### [Technical Problem]

Solution to Problem of the present invention provides a solar cell, a method for manufacturing a solar cell, a multi-junction solar cell, a solar cell module, and a photovoltaic power generation system having excellent conversion efficiency.

### [Solution to Problem]

A solar cell of an embodiment includes a p-electrode, a p-type light-absorbing layer containing a cuprous oxide and/or a complex oxide of cuprous oxides on the p-electrode, an n-type layer on the p-type light-absorbing layer, and an n-electrode, when a first region is a region of the p-type light-absorbing layer from an interface between the p-type light absorbing layer and the n-type layer to a depth of 10 nm toward the p-electrode and a second region is a region of the p-type light-absorbing layer from the interface between the p-type light absorbing layer and the n-type layer to a depth of 100 nm toward the p-electrode excluding the first region, a maximum intensity of an intensity profile of a HAADF-STEM image of the first region is 95 % or more and 105 % or less of an average intensity of an intensity profile of a HAADF-STEM of the second region.

### [Brief Description of Drawings]

[FIG. 1] FIG. 1 is a cross-sectional view of a solar cell according to an embodiment.
[FIG. 2] FIG. 2 is a diagram illustrating analysis spots of a solar cell according to an embodiment.
[FIG. 3] FIG. 3 is a HAADF-STEM image according to a reference example and an intensity profile.
[FIG. 4] FIG. 4 is a HAADF-STEM image according to a reference example and an intensity profile.
[FIG. 5] FIG. 5 is a flowchart of a method for manufacturing a stacked body and a solar cell according to an embodiment.
[FIG. 6] FIG. 6 is a cross-sectional view of a multi-junction solar cell according to an embodiment.
[FIG. 7] FIG. 7 is a perspective view of a solar cell module according to an embodiment.
[FIG. 8] FIG. 8 is a cross-sectional view of a solar cell module according to an embodiment.
[FIG. 9] FIG. 9 is a structural view of a photovoltaic power generation system according to an embodiment.
[FIG. 10] FIG. 10 is a conceptual diagram of a vehicle according to an embodiment.

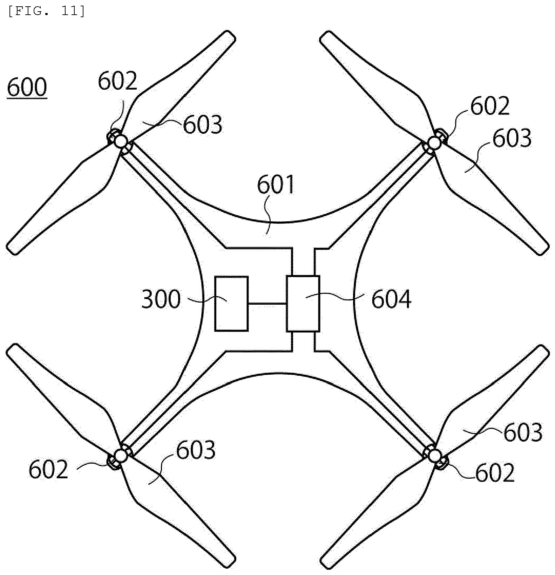

[FIG. 11] FIG. 11 is conceptual diagram of a flying object according to an embodiment.
[FIG. 12] FIG. 12 is a table related to Examples.
[FIG. 13] FIG. 13 is a table related to Examples.

### [Description of Embodiments]

Hereinafter, an embodiment will be described in detail with reference to the drawings. Unless otherwise specified, values at 25 °C and 1 atm (atmosphere) are shown. An average represents an arithmetic mean value.

### (First Embodiment)

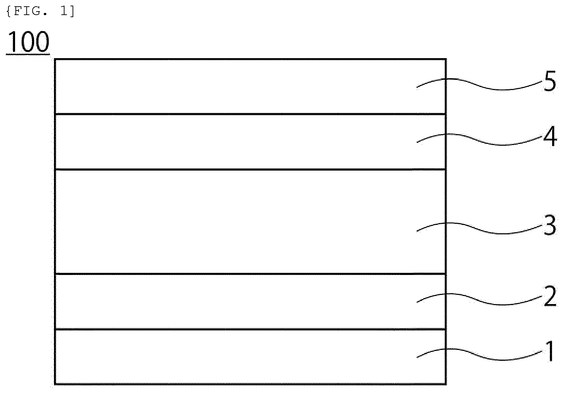

A first embodiment relates to a solar cell and a method for manufacturing a solar cell. A cross-sectional view of the solar cell according to the first embodiment is illustrated. As Illustrated in FIG. 1, the solar cell 100 according to present embodiment includes a substrate 1, a p-electrode 2 as a first electrode, a p-type light-absorbing layer 3, an n-type layer 4, and an n-electrode 5 as a second electrode. An intermediate layer which is not illustrated may be included between, for example, the n-type layer 4 and the n-electrode 5. Sunlight may be incident from either the n-electrode 5 side or the p-electrode 2 side, but is more preferably incident from the n-electrode 5 side. Since the solar cell 100 according to the embodiment is a transparent solar cell, it is preferable that the solar cell 100 is used as a top cell (light incident side) of a multi-junction solar cell. In FIG. 1, the substrate 1 is provided on a side of the p-electrode 2 opposite to the p-type light-absorbing layer 3 side. In the solar cell 100 of the embodiment, light is incident from the n-electrode 5 side toward the p-electrode 2 side.

The substrate 1 is a transparent substrate. A transparent organic substrates such as acrylic, polyimide, polycarbonate, polyethylene terephthalate (PET), polypropylene (PP), fluorine-based resins (polytetrafluoroethylene (PTFE), perfluoroethylene propene copolymer (FEP), ethylene tetrafluoroethylene copolymer (ETFE), polychlorotrifluoroethylene (PCTFE), perfluoroalkoxy alkane (PFA), and the like), polyarylate, polysulfone, polyethersulfone, and polyetherimide, and inorganic substrates such as soda lime glass, white glass, chemically strengthened glass, and quartz can be used as the substrate 1. As the substrate 1, the substrates listed above can be stacked. A solar cell 100 without the substrate 1 is included in embodiments.

The p-electrode 2 is provided on the substrate 1 and is disposed between the substrate 1 and the p-type light-absorbing layer 3. The p-electrode 2 is a conductive layer having transparency provided on the p-type light-absorbing layer 3 side. A thickness of the p-electrode 2 is typically 100 nm or more and 2,000 nm or less. In FIG. 1, the p-electrode 2 is in direct contact with the light-absorbing layer 3. When the solar cell 100 has transparency, it is preferable that the p-electrode 2 includes one or more layers of transparent conductive oxide films (semiconductor conductive films). When the solar cell has not transparency, a metal film which does not transmit light such as Au, Ag and the like whose thickness is 100 nm or more may be used as the p-electrode 2. The transparent conductive oxide film is not particularly limited, and is an indium tin oxide (ITO), an Al-doped zinc oxide (AZO), a boron-doped zinc oxide (BZO), a gallium-doped zinc Oxide (GZO), a doped tin oxide, a titanium-doped indium oxide (ITiO), an indium zinc oxide (IZO), an indium gallium zinc oxide (IGZO), a hydrogen-doped indium oxide (IOH), or the like. The transparent conductive oxide film may be a stacked film having a plurality of films.

A dopant for a film of tin oxide or the like is not particularly limited as long as the dopant is one or more elements selected from the group consisting of In, Si, Ge, Ti, Cu, Sb, Nb, Ta, W, Mo, F, Cl, and the like. It is preferable that the p-electrode 2 includes the doped tin oxide. When the doped tin oxide is included in the p-electrode 2, the doped tin oxide is in direct contact with the p-type light-absorbing layer 3. When a doped tin oxide film is included in the p-electrode 2, it is preferable that the doped tin oxide film is provided on a surface of the p-electrode 2 which faces the p-type light-absorbing layer 3 and is preferable that the doped tin oxide film is in direct contact with the p-type light-absorbing layer 3. It is preferable that the p-electrode 2 preferably includes a tin oxide film doped with one or more elements selected from the group consisting of In, Si, Ge, Ti, Cu, Sb, Nb, Ta, W, Mo, F, Cl, and the like. In the doped tin oxide film, one or more elements selected from the group consisting of In, Si, Ge, Ti, Cu, Sb, Nb, Ta, W, Mo, F, Cl, and the like are preferably contained at 10 atom% or less with respect to tin contained in the tin oxide film.

As the p-electrode 2, a stacked film in which a transparent conductive oxide film and a metal film are stacked can be used. The metal film preferably has a thickness of 10 nm or less, and the metal (including alloy) contained in the metal film is not particularly limited to Mo, Au, Cu, Ag, Al, Ta, W, or the like. It is preferable that the p-electrode 2 includes a dot-shaped, line-shaped, or mesh-shaped electrode (one or more selected from the group consisting of metal, an alloy, graphene, a conductive nitride, and a conductive oxide) between the transparent conductive oxide film and the substrate 1 or between the transparent conductive oxide film and the p-type light-absorbing layer 3. It is preferable that the dot-shaped meatal, the line-shaped metal, or the mesh-shaped metal has an aperture ratio of 50 % or more with respect to the transparent conductive film. The dot-shape metal, the line-shape metal, or the mesh-like metal is not particularly limited, and is Mo, Au, Cu, Ag, Al, Ta, W, or the like. It is preferable that the dot-shaped, line-shaped, or mesh-shaped metal has an aperture ratio of 50% or more with respect to the transparent conductive film. When the metal film is used for the p-electrode 2, it is preferable that a film thickness is about 5 nm or less from the viewpoint of transparency. When the line-shaped or mesh-shaped metal film is used, since the transparency is obtained owing to the opening, the film thickness of the metal film is not limited thereto.

A method for forming the p-electrode 2 on the substrate 1 is, for example, forming the transparent conductive oxide film by sputtering on the substrate 1. When the metal film, the mesh-shaped metal or the line-shaped metal is included in the p-electrode 2, the metal is formed and patterned as needed.

The p-type light-absorbing layer 3 is a p-type semiconductor layer. The p-type light-absorbing layer 3 may be in direct contact with the p-electrode 2, or other layers may be present as long as the contact with the p-electrode 2 can be secured. The p-type light-absorbing layer 3 is disposed between the p-electrode 2 and the n-type layer 4. The p-type light-absorbing layer 3 is in direct contact with the n-type layer 4. The p-type light-absorbing layer 3 is a semiconductor layer of a metal oxide containing Cu as a main component. The metal oxide containing Cu as the main component is a cuprous oxide or/and a complex oxide of cuprous oxides. In other words, the p-type light-absorbing layer 3 is a layer mainly containing the cuprous oxide or/and the complex oxide of cuprous oxides . It is preferable that the p-type light absorbing layer 3 is polycrystalline of the cuprous oxide and/or the complex oxide of cuprous oxides . The cuprous oxide and/or the complex oxide of cuprous oxides is an oxide represented by CuₐM1_{b}O_{c}. It is preferable that the M1 is one or more elements selected from the group consisting of Sn, Sb, Ag, Li, Na, K, Cs, Rb, Al, In, Zn, Mg, and Ca. a, b, and c preferably satisfy 1.80 ≤ a ≤ 2.01, 0.00 ≤ b ≤ 0.20, and 0.98 ≤ c ≤ 1.02. 90 wt% or more of the p-type light-absorbing layer 3 is preferably the cuprous oxide or/and the complex oxide of cuprous oxides. 95 wt% or more of the p-type light-absorbing layer 3 is more preferably the cuprous oxide or/and the complex oxide of cuprous oxides. 98 wt% or more of the p-type light-absorbing layer 3 is still more preferably the cuprous oxide or/and the complex oxide of cuprous oxides. It is preferable that the p-type light-absorbing layer 3 hardly contains Cu or/and CuO which is a heterogeneous phase. Since the p-type light-absorbing layer 3 contains less heterogeneous phases and has good crystallinity, it is preferable that the transmittance of the p-type light-absorbing layer 3 is increased. When the element of M2 is contained in the p-type light-absorbing layer 3, a band gap of the p-type light-absorbing layer 3 can be adjusted. The band gap of the p-type light-absorbing layer 3 is preferably 2.0 eV or more and 2.2 eV or less. When the band gap is in such a range, sunlight can be efficiently used in both a top cell and a bottom cell in the multi-junction solar cell in which the solar cell using Si for the light-absorbing layer is used as the bottom cell and the solar cell of the embodiment is used as the top cell. The p-type light-absorbing layer 3 may further contain Sn and/or Sb. Sn or Sb in the p-type light-absorbing layer 3 may be added to the light-absorbing layer 3 or may be derived from the p-electrode 2. Hereinafter, the explanation about the cuprous oxide includes the explanation of the complex oxide of cuprous oxides.

The elements of Cu, M1, and the like included in the p-type light-absorbing layer 3 and the elements of Ga, M2, and the like included in the n-type layer 4 may be partially diffused in the vicinity of the interface between the p-type light-absorbing layer 3 and the n-type layer 4.

The above composition ratio of the p-type light-absorbing layer 3 is an entire composition ratio of the p-type light absorbing layer 3. It is preferable that the above composition ratio of the compound of the p-type light-absorbing layer 3 satisfies entirely in the p-type light-absorbing layer 3. When the concentration of Sn and Sb is high in the p-type light-absorbing layer 3, carrier re-combination is increased owing to increasing of defects. Therefore, it is preferable that a total volume concentration of the Sb and Sn in the p-type light-absorbing layer 3 is 1.5 × 10¹⁹ atoms/cm³ or less.

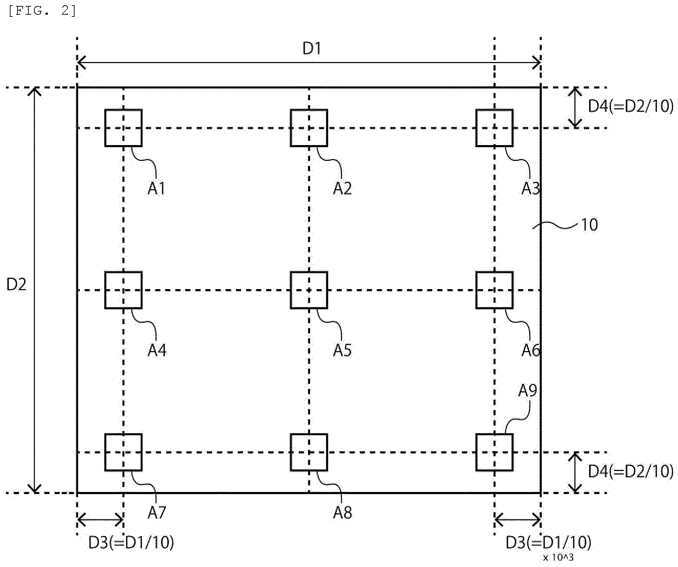

When a thickness of the p-type light-absorbing layer 3 is d₃, the composition of the p-type light-absorbing layer is an average value of the compositions at depths of 0.2d₃, 0.5d₃, and 0.8d₃ from a surface of the p-type light absorbing layer 3 on the p-electrode 2 side. Unless there is a condition that an elemental composition ratio of the compound of the p-type light-absorbing layer 3 is inclined, the p-type light-absorbing layer preferably satisfies the above compositions and the following suitable compositions at each depth. In the analysis, analysis spots (A1-A9) distributed as evenly as possible at equal intervals as represented in analysis spots of FIG. 2 at each distance from the surface of the n-type layer 4 are analyzed by, for example, secondary ion mass spectrometry (SIMS) . FIG. 2 is a schematic diagram of the solar cell 100 as viewed from the light incident side. When the p-type light absorbing layer 3 is analyzed, D1 is a length of the p-type light-absorbing layer 3 in a width direction, and D2 is a length of the light absorbing layer 3 in a depth direction.

A thickness of the p-type light-absorbing layer 3 is obtained by cross-sectional observation with an electron microscope or a step profiler, and is preferably 1,000 nm or more and 10,000 nm or less.

The n-type layer 4 is an n-type semiconductor layer. The n-type layer 4 is located between the p-type light-absorbing layer 3 and the n-electrode 5. The n-type layer 4 is in direct contact with a surface of the p-type light-absorbing layer 3 opposite to a surface in contact with the p-electrode 2. The n-type layer 4 is a semiconductor layer containing an oxide or a sulfide. It is preferable that the n-type layer 4 includes at least one of an oxide and a sulfide. It is preferable that the n-type layer 4 contains an oxide having Ga as a base. It is preferable that the n-type layer 4 contains an oxide or a sulfide which includes at least one from the group consisting of Ga, Al, B, In, Ti, Zn, Hf, Zr, Cd, Sn, Si and Ge.

The n-type layer 4 is one layer or stacked layers. It is preferable that the n-type layer 4 includes an oxide which is one layer or stacked layers or a sulfide which is one layer or stacked layers. The n-type layer 4 may be one layer having inclined composition or be stacked layers that each layer of the stacked layers has inclined composition. When the n-type layer 4 is stacked layers, the stacked layers are a first n-type layer and a second n-type layer in this order from the p-type light-absorbing layer 3. For example, when the n-type layer 4 is three layers, a first n-type layer, a second n-type layer, and a third n-type layer are stacked. A surface of the first n-type layer which is facing to the p-type light-absorbing layer 3 is in direct contact with the p-type light-absorbing layer 3. When the n-type layer 4 is stacked layers, it is preferable that all of layers are oxide layers or sulfide layers.

When the n-type layer 4 contains oxide, it is preferable that the oxide of the n-type layer 4 is an oxide which contains one or more elements selected from the group consisting of Ga, Al, B, In, Ti, Zn, Hf, Zr, Sn, Si and Ge. The oxide of the n-type layer is easy to extract oxygen which is bonded to Cu of the cuprous oxide and/or the complex oxide of cuprous oxides when the n-type layer 4 is formed. The sulfide of the n-type layer 4 may contain Cu and the element of M1 which are diffused from the cuprous oxide and/or the complex oxide of cuprous oxides. When the n-type layer 4 is stacked layers contains oxides, it is preferable that Ga ratio to metal elements in the oxide of one or more layers of the n-type layer is 50 atom% or more. When the n-type layer 4 is stacked layers contains oxides, it is preferable that Ga ratio to metal elements in the oxide of at least the first n-type layer is 50 atom % or more.

When the n-type layer 4 contains sulfide, it is preferable that the sulfide of the n-type layer 4 is a sulfide which contains one or more elements selected from the group consisting of Ga, In, Zn, and, Cd. It is more preferable that the sulfide of the n-type layer 4 is a sulfide which contains Zn and In, a sulfide which contains Cd and Zn, or a sulfide which contains In and Ga. The sulfide of the n-type layer 4 is easy to extract oxygen which is bonded to Cu of the cuprous oxide and/or the complex oxide of cuprous oxides when the n-type layer 4 is formed. The sulfide of the n-type layer 4 may contain Cu, the element of M1, and O which are diffused from the cuprous oxide and/or the complex oxide of cuprous oxides.

A composition of the compound of the n-type layer 4 is an average composition of the entire n-type layer 4 unless otherwise specified. When a thickness of the n-type layer 4 is d₄, the composition of the n-type layer 4 is an average value of the compositions at depths of 0.2d₄, 0.5d₄, and 0.8d₄ from a surface (interface between the p-type light-absorbing layer 3 and the n-type layer 4) of the n-type layer 4 on the p-type light-absorbing layer 3 side. When the n-type layer 4 is very thin (for example, 5 nm or less), the composition at a depth of 0.5d from the surface of the n-type layer 4 on the p-type light-absorbing layer 3 side can be regarded as the composition of the entire n-type layer 4. In the analysis, analysis spots (A1 ~ A9) distributed as evenly as possible at equal intervals as represented in analysis spots of FIG. 2 at each distance from the surface of the n-type layer 4 are analyzed by, for example, secondary ion mass spectrometry (SIMS) . FIG. 2 is a schematic diagram of the solar cell 100 as viewed from the light incident side. D1 is a length of the n-type layer 4 in a width direction, and D2 is a length of the n-type layer 4 in a depth direction.

It is preferable that there is little Cu phase which is heterogeneous phase of the cuprous oxide in the interface between the p-type light-absorbing layer 3 and the n-type layer 4. The heterogeneous phase of the cuprous oxide and the complex oxide of cuprous oxides which can be exist in the interface between the p-type light-absorbing layer 3 and the n-type layer 4 may be Cu phase and CuO phase. Even if there is no Cu phase on a surface of the p-type light-absorbing layer 3 before forming the n-type layer 4, Cu is easily deposited in the vicinity of the interface between the p-type light-absorbing layer 3 and the n-type layer 4 after forming the n-type layer 4 since Cu₂O is reduced by extracting oxygen by the element of M2 which is contained in the oxide or the sulfide during forming the n-type layer 4. When the Cu phase exists in the vicinity of the p-type light-absorbing layer 3 and the n-type layer 4, it may cause decreasing a conversion efficiency due to increasing of re-combination in the p-type light absorbing layer 3 and decreasing Voc. Since the amount of the Cu which exists in the vicinity of the interface between the p-type light absorbing layer 3 and the n-type layer 4 is very small, it is difficult to analyze directly the position of the Cu phase and the amount of the Cu phase. It was difficult to evaluate the amount of the Cu phase in the vicinity of the interface between the p-type light-absorbing layer 3 and the n-type layer 4.

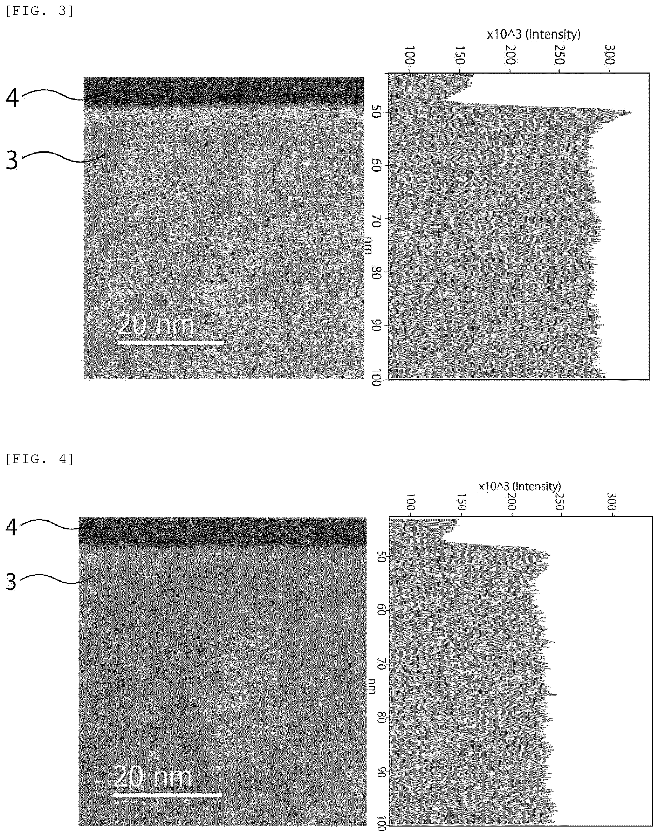

The inventors discovered that the Cu phase is included in a high intensity region from an intensity profile of High-Angle Annular Dark Field Scanning Transmission Electron Microscopy (HAADF-STEM) image focused on intensity in the vicinity of the interface between the p-type light-absorbing layer 3 and the n-type layer 4. A HAADF-STEM image and an intensity profile of a reference example are shown in FIG. 3. The HAADF-STEM image of FIG. 3 teaches that a high intensity region exists in the vicinity of the p-type light-absorbing layer 3 and the n-type layer 4. By analyzing this region, it was discovered it is Cu phase. The Cu phase is confirmed after forming the n-type layer 4 even if a member having a surface on which Cu phase is no confirmed before forming the n-type layer 4 is used as the layer containing the cuprous oxide and/or the complex oxide of cuprous oxides as a main component. The inventors discovered how to reduce or extinguish the Cu phase. Comparing Voc and conversion efficiency of a solar cell (reference example) in which the Cu phase remains and Voc and conversion efficiency of a solar cell according to an embodiment, a tendency of increasing Voc and a conversion efficiency of the solar cell according to an embodiment was confirmed.

The inventors discovered a following evaluation method that Cu phase in the vicinity of the interface between the p-type light-absorbing layer 3 of the p-type light absorbing layer 3 and the n-type layer 4 has correlation with Voc and conversion efficiency. Since it is difficult to analyze the amount of Cu phase directly, Cu phase is evaluated from an intensity profile of a HAADF-STEM image.

A HAADF-STEM image and an intensity profile of a solar cell according to embodiment are shown in FIG. 4. In the intensity profile of FIG 4, a peak which has obviously high intensity in a region of the p-type light-absorbing layer 3 on the n-type layer 4 side. A first region is a region of the p-type light-absorbing layer 3 from an interface between the p-type light absorbing layer 3 and the n-type layer 4 to a depth of 10 nm toward the p-electrode 2. A second region is a region of the p-type light-absorbing layer 3 from the interface between the p-type light absorbing layer 3 and the n-type layer 4 to a depth of 100 nm toward the p-electrode 2 excluding the first region. A third region is a region (bulk) of the p-type light absorbing layer 3 in which the first region and the second region are excluded, it is preferable that the third region also satisfies the same following conditions of the intensity profile as the second region.

The interface between the p-type light-absorbing layer 3 and the n-type layer 4 may not be clear. When the interface between the p-type light-absorbing layer 3 and the n-type layer 4 is not clear, the interface between the p-type light-absorbing layer 3 and the n-type layer 4 can be determined from an intensity profile of a HAADF-STEM image. A position 1 nm away from the position whose intensity is mostly decreased in the vicinity of the interface between the p-type light-absorbing layer 3 and the n-type layer 4 toward the p-electrode 2 can be determined as the interface between the p-type light-absorbing layer 3 and the n-type layer 4. The interface between the p-type light-absorbing layer 3 and the n-type layer 4 may be uneven rather than flat. The interface between the p-type light-absorbing layer 3 and the n-type layer 4 can be determined by observing a cross section of the p-type light-absorbing layer 3 and the n-type layer 4.

It is preferable that a maximum intensity of an intensity profile of a HAADF-STEM image of the first region is 95 % or more and 105 % or less of an average intensity of an intensity profile of a HAADF-STEM of the second region. When a maximum intensity of an intensity profile of a HAADF-STEM image of the first region is less than 95 % of an average intensity of an intensity profile of a HAADF-STEM of the second region, it means large amount of CuO phase exists, and it can be a factor of decreasing Voc because an appropriate p-n junction is not formed. When a maximum intensity of an intensity profile of a HAADF-STEM image of the first region is more than 105 % of an average intensity of an intensity profile of a HAADF-STEM of the second region, the first region contains Cu phase, and Voc is decreased because re-combination speed is fast in the p-type light absorbing layer 3. It is more preferable that a maximum intensity of an intensity profile of a HAADF-STEM image of the first region is 97 % or more and 103 % or less of an average intensity of an intensity profile of a HAADF-STEM of the second region. It is preferable that the layer whose main component is the cuprous oxide and/or the complex oxide of cuprous oxides before forming the n-type layer 4 satisfies the preferable intensity profile of the HAADF-STEM image of the p-type light-absorbing layer 3. The intensity profile shown in FIG. 4 satisfies above condition because the maximum intensity of the intensity profile of the HAADF-STEM image of the first region is 102 % of the average intensity of the intensity profile of the HAADF-STEM of the second region. The intensity profile shown in FIG. 3 does not satisfy above condition because the maximum intensity of the intensity profile of the HAADF-STEM image of the first region is 115 % of the average intensity of the intensity profile of the HAADF-STEM of the second region. Similarly, a maximum intensity of an intensity profile of a HAADF-STEM image of the first region is preferably 95 % or more and 105 % or less of an average intensity of an intensity profile of a HAADF-STEM of the third region, more preferably 97 % or more and 103 % or less of an average intensity of an intensity profile of a HAADF-STEM of the third region.

An intensity profile of a HAADF-STEM image is obtained by following procedures. After a sample is processed with focused ion beam (FIB), an observation of HAADF-STEM is performed using atomic resolution analytical electron microscope JEM-ARM200F Dual-X (manufactured by JEOL) at an acceleration voltage of 120 kV. An intensity profile is detected, contrast correction is performed from a depth of 20 nm from the interface between the p-type light-absorbing layer 3 and the n-type layer 4 toward the p-electrode 2 to a depth of 40 nm, and a maximum intensity is calculated with the intensity in the region as the reference. It is preferable to perform the contrast correction so that a low intensity (intensity of the n-type layer 4 on the n-electrode side) of a solar cell to which a heating according to an embodiment is performed and a low intensity of a solar cell to which a heating according to an embodiment is not performed are approximately the same and a high intensity (average intensity of the p-type light-absorbing layer 3 on the n-type layer side 4) of the solar cell to which the heating according to an embodiment is performed and a high intensity of the solar cell to which a heating according to an embodiment is not performed are approximately the same.

An average intensity of an intensity profile of a HAADF-STEM image of the first region is preferably 85 % or more and 95 % or less of an average intensity of an intensity profile of a HAADF-STEM of the second region and is more preferably 87 % or more and 93 % or less of an average intensity of an intensity profile of a HAADF-STEM of the second region. The intensity profile shown in FIG. 4 satisfies above condition because the average intensity of the intensity profile of the HAADF-STEM image of the first region is 91 % of the average intensity of the intensity profile of the HAADF-STEM of the second region. The intensity profile shown in FIG. 3 does not satisfy above condition because the average intensity of the intensity profile of the HAADF-STEM image of the first region is 98% of the average intensity of the intensity profile of the HAADF-STEM of the second region. The intensity profile according to a reference example shown in FIG.3 does not satisfy the above conditions, because the average intensity of the second region is not low, but the average intensity of the first region is high owing to a high peak in the first region. Similarly, an average intensity of an intensity profile of a HAADF-STEM image of the first region is preferably 85 % or more and 95 % or less of an average intensity of an intensity profile of a HAADF-STEM of the third region, more preferably 87 % or more and 93 % or less of an average intensity of an intensity profile of a HAADF-STEM of the third region.

A minimum intensity of an intensity profile of a HAADF-STEM image in a region of the first region from a depth of 5 nm from the interface of the p-type light-absorbing layer 3 and the n-type layer 4 toward the p-electrode 2 to a depth of 10 nm is preferably 85 % or more and 95 % or less of an average intensity of an average intensity of an intensity profile of a HAADF-STEM image of the second region and more preferably 87 % or more and 93 % or less of an average intensity of an average intensity of an intensity profile of a HAADF-STEM image of the second region. The intensity profile shown in FIG. 4 satisfies the above condition because the minimum intensity of the intensity profile of the HAADF-STEM image in the region of the first region from the depth of 5 nm from the interface of the p-type light-absorbing layer 3 and the n-type layer 4 toward the p-electrode 2 to the depth of 10 nm is 89 % of the average intensity of the average intensity of the intensity profile of the HAADF-STEM image of the second region. The intensity profile shown in FIG. 3 satisfies the above condition because the minimum intensity of the intensity profile of the HAADF-STEM image in the region of the first region from the depth of 5 nm from the interface of the p-type light-absorbing layer 3 and the n-type layer 4 toward the p-electrode 2 to the depth of 10 nm is 93 % of the average intensity of the average intensity of the intensity profile of the HAADF-STEM image of the second region. The intensity profile shown in FIG. 3 satisfies the above condition because the difference between the minimum intensity of the intensity profile of the HAADF-STEM image in the region of the first region from the depth of 5 nm from the interface of the p-type light-absorbing layer 3 and the n-type layer 4 toward the p-electrode 2 to the depth of 10 nm and the average intensity of the average intensity of the intensity profile of the HAADF-STEM image of the second region is small. Similarly, a minimum intensity of an intensity profile of a HAADF-STEM image in a region of the first region from a depth of 5 nm from the interface of the p-type light-absorbing layer 3 and the n-type layer 4 toward the p-electrode 2 to a depth of 10 nm is preferably 85 % or more and 95 % or less of an average intensity of an average intensity of an intensity profile of a HAADF-STEM image of the third region and more preferably 87 % or more and 93 % or less of an average intensity of an average intensity of an intensity profile of a HAADF-STEM image of the third region.

A minimum intensity of an intensity profile of a HAADF-STEM image of the first region is preferably 78 % or more and 85 % or less of an average intensity of an intensity profile of a HAADF-STEM of the second region and is more preferably 80 % or more and 83 % or less of an average intensity of an intensity profile of a HAADF-STEM of the second region. The intensity profile shown in FIG. 4 satisfies above condition because the minimum intensity of the intensity profile of the HAADF-STEM image of the first region is 81 % of the average intensity of the intensity profile of the HAADF-STEM of the second region. The intensity profile shown in FIG. 3 satisfies above condition because the minimum intensity of the intensity profile of the HAADF-STEM image of the first region is 80 % of the average intensity of the intensity profile of the HAADF-STEM of the second region. The intensity profile according to a reference example shown in FIG. 3 satisfies the above conditions, because no obvious peak in the second region but the bottom of the peak is low. Similarly, a minimum intensity of an intensity profile of a HAADF-STEM image of the first region is preferably 78 % or more and 85 % or less of an average intensity of an intensity profile of a HAADF-STEM of the third region, more preferably 80 % or more and 83 % or less of an average intensity of an intensity profile of a HAADF-STEM of the third region.

An average intensity of an intensity profile of a HAADF-STEM image of the first region is preferably 85 % or more and 95 % or less of a maximum intensity of an intensity profile of a HAADF-STEM of the first region, is more preferably 87 % or more and 93 % or less of a maximum intensity of an intensity profile of a HAADF-STEM of the first region, is preferably 110 % or more and 120 % or less of a minimum intensity of an intensity profile of a HAADF-STEM of the first region, and is more preferably 112 % or more and 118 % or less of a minimum intensity of an intensity profile of a HAADF-STEM of the first region. The intensity profile shown in FIG. 4 satisfies above conditions because the average intensity of the intensity profile of the HAADF-STEM image of the first region is 90 % of the maximum intensity of the intensity profile of the HAADF-STEM of the first region and is 113 % of the minimum intensity of the intensity profile of the HAADF-STEM of the first region. The intensity profile shown in FIG. 3 does not satisfy above condition because the average intensity of the intensity profile of the HAADF-STEM image of the first region is 79 % of the maximum intensity of the intensity profile of the HAADF-STEM of the first region. The intensity profile according to a reference example shown in FIG.3 does not satisfy the above conditions, because the bottom of peak is low and the top of the peak is high in the first region.

An average intensity of an intensity profile of a HAADF-STEM image of the second region is preferably 90 % or more and 99 % or less of a maximum intensity of an intensity profile of a HAADF-STEM of the second region, is more preferably 92 % or more and 97 % or less of a maximum intensity of an intensity profile of a HAADF-STEM of the second region, is preferably 101 % or more and 110 % or less of a minimum intensity of an intensity profile of a HAADF-STEM of the second region, and is more preferably 103 % or more and 108 % or less of a minimum intensity of an intensity profile of a HAADF-STEM of the second region. The intensity profile shown in FIG. 4 satisfies above conditions because the average intensity of the intensity profile of the HAADF-STEM image of the second region is 95 % of the maximum intensity of the intensity profile of the HAADF-STEM of the second region and is 108 % of the minimum intensity of the intensity profile of the HAADF-STEM of the second region. The intensity profile shown in FIG. 3 satisfies above conditions because the average intensity of the intensity profile of the HAADF-STEM image of the second region is 97 % of the maximum intensity of the intensity profile of the HAADF-STEM of the second region and is 103 % of the minimum intensity of the intensity profile of the HAADF-STEM of the second region. The intensity profile according to a reference example shown in FIG.3 also satisfies the above conditions, because a bulk (the second region) of the p-type light absorbing layer has excellent crystallinity and little different phase according to the reference example of FIG. 3. Similarly, an average intensity of an intensity profile of a HAADF-STEM image of the third region is preferably 90 % or more and 99 % or less of a maximum intensity of an intensity profile of a HAADF-STEM of the third region, is more preferably 92 % or more and 97 % or less of a maximum intensity of an intensity profile of a HAADF-STEM of the third region, is preferably 101 % or more and 110 % or less of a minimum intensity of an intensity profile of a HAADF-STEM of the third region, and is more preferably 103 % or more and 108 % or less of a minimum intensity of an intensity profile of a HAADF-STEM of the third region.

The n-electrode 5 is an electrode on the n-type layer 4 side which preferably has transparency to visible light. The n-type layer 4 is sandwiched between the n-electrode 5 and the p-type light-absorbing layer 3. An intermediate layer which is not illustrated can be provided between the n-type layer 4 and the n-electrode 5. The intermediate layer can include a mesh-shaped or line-shaped electrode . It is preferable that a transparent conductive oxide film (semiconductor conductive film) is used for the n-electrode 5. It is preferable that the transparent conductive oxide film used for the n-electrode 5 is one or more kinds of transparent conductive films selected from the group consisting of an indium tin oxide, an aluminum-doped zinc oxide, a boron-doped zinc oxide, a gallium-doped zinc oxide, an indium-doped zinc oxide, a titanium-doped indium oxide, an indium gallium zinc oxide, and a hydrogen-doped indium oxide. Graphene may be used for the n-electrode 5. It is preferable that graphene is stacked with Ag nano wires. When the solar cell 100 is not transparent type and the p-electrode 2 has transparency to visible light, a metal film whose thickness is more than 100 nm likewise the p-electrode 2 can be used for the n-electrode 5.

A thickness of the n-electrode 5 is obtained by cross-sectional observation with an electron microscope or a step profiler, and is not particularly limited, but is typically 1 nm or more and 2 um or less.

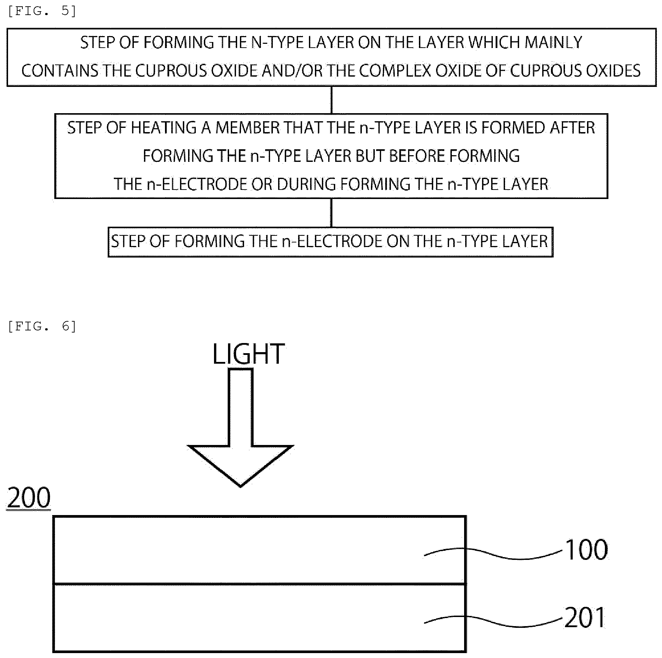

Next, a method for manufacturing the solar cell 100 will be described. FIG. 5 illustrates a flowchart of a method for manufacturing the solar cell 100 according to an embodiment. A method for manufacturing the solar cell 100 of the embodiment includes a step of forming the n-type layer 4 on the layer which mainly contains the cuprous oxide and/or the complex oxide of cuprous oxides, a step of forming the n-electrode 5 on the n-type layer 4, and a step of heating a member that the n-type layer 4 is formed after forming the n-type layer but before forming the n-electrode or during forming the n-type layer.

The layer which mainly contains the cuprous oxide and/or the complex oxide of cuprous oxides is a precursor of the p-type light absorbing layer 3. The layer which mainly contains the cuprous oxide and/or the complex oxide of cuprous oxides becomes the p-type light-absorbing layer 3 by heating the n-type layer 4 partly or entirely. In the step of forming the n-type layer 4 on the layer which mainly contains the cuprous oxide and/or the complex oxide of cuprous oxides, the layer which mainly contains the cuprous oxide and/or the complex oxide of cuprous oxides is the layer which mainly contains the cuprous oxide and/or the complex oxide of cuprous oxides provided on the p-electrode 2 which is on the substrate 1, the layer which mainly contains the cuprous oxide and/or the complex oxide of cuprous oxides provided on the p-electrode 2, or the film alone that mainly contains the cuprous oxide and/or the complex oxide of cuprous oxides.

The layer which mainly contains the cuprous oxide and/or the complex oxide of cuprous oxides provided on the p-electrode 2 which is on the substrate 1 is obtained by forming the p-electrode 2 on the substrate 1 and forming the layer which mainly contains the cuprous oxide and/or the complex oxide of cuprous oxides . When the substrate 1 is not used, the layer which mainly contains the cuprous oxide and/or the complex oxide of cuprous oxides may be formed on the p-electrode 2 or the p-electrode 2 is formed on the layer which mainly contains the cuprous oxide and/or the complex oxide of cuprous oxides.

As the step of forming the layer which mainly contains the cuprous oxide and/or the complex oxide of cuprous oxides on the p-electrode 2, the layer which mainly contains the cuprous oxide and/or the complex oxide of cuprous oxides is formed on the p-electrode 2. It is preferable that the layer which mainly contains the cuprous oxide and/or the complex oxide of cuprous oxides is formed by sputtering . It is preferable that the layer which mainly containing the cuprous oxide and/or the complex oxide of cuprous oxides having little heterogeneous phases is formed. It is preferable that sputtering is performed by heating the member in which the p-electrode 2 is formed on the substrate 1 to a temperature of 300 °C or more and 600 °C or less in a range of an oxygen partial pressure of 0.01 [Pa] or more and 4.8 [Pa] or less in a range of 0.02 µm/min or more and 20 µm/min or less. A temperature of a member that the p-electrode 2 is formed on the substrate 1 is regarded as the same temperature of the stage. From the viewpoint of forming a polycrystalline film having high transparency and a large particle diameter, when a deposition rate is d, the oxygen partial pressure more preferably satisfies 0.55 x d [Pa] or more and 1.00 x d [Pa] or less. The heating temperature is more preferably 350 °C or more and 500 °C or less. The element of M1 can be added during the formation of the layer which mainly contains the cuprous oxide and/or the complex oxide of cuprous oxides.

As a method forming the layer which mainly contains the cuprous oxide and/or the complex oxide of cuprous oxides, the layer which mainly contains the cuprous oxide and/or the complex oxide of cuprous oxides can be obtained by heating a Cu plate in an oxygen atmosphere. A cuprous oxide film can be doped with the element of M1 by ion implantation into the cuprous oxide film.

The step of forming the n-type layer 4 on the layer which mainly contains the cuprous oxide and/or the complex oxide of cuprous oxides includes forming the n-type layer 4 on the layer which mainly contains the cuprous oxide and/or the complex oxide of cuprous oxides provided on the p-electrode 2 on the substrate 1, the layer which mainly contains the cuprous oxide and/or the complex oxide of cuprous oxides provided on the p-electrode 2, or the film alone which mainly contains the cuprous oxide and/or the complex oxide of cuprous oxides. The n-type layer 4 may be formed by depositing of an atomic layer deposition or the like on the layer which mainly contains the cuprous oxide and/or the complex oxide of cuprous oxides or transferring and heating the n-type layer 4 on the layer which mainly contains the cuprous oxide and/or the complex oxide of cuprous oxides. The n-type layer 4 and the p-type light-absorbing layer 3 are bonded by heating after transferring . The Cu phase in the first region on a side surface of the film which contains mainly cuprous oxide and the complex oxide of cuprous oxide where the n-type layer is formed is supposed to be deposited during depositing the n-type layer 4 or heating after the transferring, in other words when or after crystals of the oxide of the sulfide of the n-type layer 4 is bond to the cuprous oxide and/or the complex oxide of cuprous oxide by heating.

The temperature of the film which contains mainly cuprous oxide and the complex oxide of cuprous oxide while the n-type layer 4 is deposited is, for example, 100 °C or more and 150 °C or less. It is preferable that the n-type layer 4 is deposited in a sulfuric or oxidizing atmosphere on the film which contains mainly cuprous oxide and the complex oxide of cuprous oxide.

The step of heating a member that the n-type layer 4 is formed after forming the n-type layer but before forming the n-electrode or during forming the n-type layer is a step of oxidizing the deposited Cu phase. The heating is performed after forming the one layer of n-type layer 4 but before forming the n-electrode 5 or after forming one or more layers of stacked layers of the n-type layer 4 but before forming the n-electrode 5. When the heating for oxidizing the Cu phase is performed in an oxidizing atmosphere, the cuprous oxide is oxidized and become CuO. If the CuO phase exists, characteristics of the transparency and the power generation are greatly decreased. Therefore, it is preferable that the step of heating is performed in a non-oxidizing atmosphere. When the heating is performed, the p-electrode 2 may be formed but the n-electrode 5 is not formed.

The step of heating is performed with the member that the n-type layer 4 is formed on the layer which mainly contains the cuprous oxide and/or the complex oxide of cuprous oxides in a closed container, in a glove box with flowing inactive gas, or on a stage of a vacuum chamber. A treatment such as oxidizing a surface of the layer which mainly contains the cuprous oxide and the complex oxide of cuprous oxides after forming the layer which mainly contains the cuprous oxide and the complex oxide of cuprous oxides but before forming the n-type layer 4. When this oxidizing is performed, the step of heating is effective because the Cu is deposited during forming the n-type layer 4.

A specific time is required to become an atmosphere of the following condition due to change the atmosphere for forming the n-type layer 4 to the atmosphere for the step of heating. When an oxygen partial pressure is high and the temperature is high, the Cu phase is excessively oxidized. Therefore, it is preferable that the atmosphere of the container is adjusted to a preferable oxygen concentration after decreasing the temperature to a room temperature or higher and 100 °C or lower of the layer which mainly contains the cuprous oxide and/or the complex of cuprous oxides. Other than that, the member in which the n-type layer 4 is formed is moved to a container where the oxygen concentration is preferably adjusted.

It is preferable that the temperature of the layer which mainly contains the cuprous oxide and/or the complex oxide of cuprous oxides in the step of heating is 150 °C or higher and 250 °C or lower. If the temperature is too low, the step of heating has substantially no effect because most of the Cu phase remains. If the temperature is too high, not only the Cu phase is oxidized to CuO phase, but cuprous oxide of the layer which mainly contains the cuprous oxide and/or the complex oxide of cuprous oxides becomes cupric oxide. Furthermore, there is some possibility to decrease the characteristics of the p-type light-absorbing layer 3 and the n-type layer 4 because a metal element contained in the n-type layer 4 is diffused to the layer which mainly contains the cuprous oxide and/or the complex of cuprous oxides and a metal element in the layer which mainly contains the cuprous oxide and/or the complex oxide of cuprous oxides is diffused to the n-type layer 4. For these reasons, the temperature of the layer which mainly contains the cuprous oxide and/or the complex oxide of cuprous oxides in the step of heating is preferably 160 °C or higher and 230 °C or lower, and more preferably 170 °C or higher and 220 °C or lower.

It is preferable that the duration of the step of heating is 5 minutes or more and 60 minutes or less. If the treatment is too short, the reaction from the copper phase to the cuprous oxide phase does not proceed sufficiently. If the duration is too long, not only the Cu phase becomes the CuO phase but cuprous oxide of the cuprous oxide and/or the complex oxide of cuprous oxide becomes cupric oxide. Additionally, a long-duration treatment is not economical. Therefore, the duration of the step of heating is preferably 15 minutes or more and 50 minutes or less and more preferably 15 minutes or more and 45 minutes or less. When the temperature of the layer which mainly contains the cuprous oxide and/or the complex oxide of cuprous oxides is 150 °C or higher and 180 °C or lower, the duration of the step of heating is preferably 20 minutes or more and 60 minutes or less and more preferably 30 minutes or more and 60 minutes or less. When the temperature of the layer which mainly contains the cuprous oxide and/or the complex oxide of cuprous oxides is 170 °C or higher and 220 °C or lower, the duration of the step of heating is preferably 10 minutes or more and 50 minutes or less and more preferably 10 minutes or more and 40 minutes or less . When the temperature of the layer which mainly contains the cuprous oxide and/or the complex oxide of cuprous oxides is 210 °C or higher and 250 °C or lower, the duration of the step of heating is preferably 5 minutes or more and 40 minutes or less and more preferably 5 minutes or more and 30 minutes or less. When the temperature of the layer which mainly contains the cuprous oxide and/or the complex oxide of cuprous oxides is 150 °C or higher and 220 °C or lower, the duration of the step of heating is preferably 10 minutes or more and 60 minutes or less and more preferably 20 minutes or more and 50 minutes or less. When the temperature of the layer which mainly contains the cuprous oxide and/or the complex oxide of cuprous oxides is 210 °C or higher and 250 °C or lower, the duration of the step of heating is preferably 5 minutes or more and 50 minutes or less and more preferably 5 minutes or more and 40 minutes or less.

It is preferable that the oxygen concentration (Mass[g]/Volume[L]) of the atmosphere of the step of heating is 8.0 x 10⁻⁴ [g/L] or less. The oxygen in the atmosphere whose oxygen concentration is very low in the step of heating is unlikely to oxidize the Cu phase. When the oxygen concentration is high, not only the Cu phase becomes the CuO phase but cuprous oxide of the cuprous oxide and/or the complex oxide of cuprous oxide becomes cupric oxide. Therefore, the oxygen concentration of the atmosphere in the step of heating is preferably 5.0 × 10⁻⁸ [g/L] or more and 8.0 × 10⁻⁴ [g/L] or less, more preferably 5.0 × 10⁻⁸ [g/L] or more and 2.0 × 10⁻⁴ [g/L] or less, and still more preferably 5.0 × 10⁻⁸ [g/L] or more and 1.0 × 10⁻⁴ [g/L] or less. In the same viewpoint with respect to ozone, the ozone concentration (Mass [g] /Volume [L]) of the atmosphere in the step of heating is preferably 0.0 [g/L] or more and 5.0 × 10⁻⁴ [g/L] or less, more preferably 0.0 [g/L] or more and 2.0 × 10⁻⁴ [g/L] or less, and still more preferably 0.0 [g/L] or more and 1.4 × 10⁻⁴ [g/L] or less. The ozone concentration is preferably lower than the oxygen concentration and more preferably 1/10 or less of the oxygen concentration. In the same viewpoint with respect to water vapor concentration (Mass[g]/Volume[L]), the partial pressure of the water vapor of the atmosphere of the step of heating is preferably 8.0 × 10⁻⁴ [g/L] or less, more preferably 5.0 × 10⁻⁸ [g/L] or more and 8.0 × 10⁻⁴ [g/L] or less, and still more preferably 5.0 × 10⁻⁸ [g/L] or more and 2.0 × 10⁻⁴ [g/L] or less .

The total pressure of the non-oxidizing atmosphere of the step of the heating is not particularly limited and is preferably 100 Pa or more and 200,000 Pa or less. The non-oxidizing atmosphere contains inactive gas of Ar or the like. The non-oxidizing atmosphere of the step of the heating may include little amount of reducing gas. The reducing gas may be included not to affect substantially the oxidizing of the Cu phase. It is preferable that the partial pressure of the reducing gas is lower than the partial pressure of the oxidizing gas.

It is preferable that the step of heating is performed before forming the n-electrode 5. When the heating is performed after forming the n-electrode 5, there is some possibility to decrease the characteristics of the n-type layer 4 and the n-electrode 5 because a metal element contained in the n-type layer 4 is diffused to the n-electrode 5 and a metal element in the n-electrode 5 is diffused to the n-type layer 4. Therefore, it is preferable that the step of heating is performed before forming the n-electrode 5.

The step of the heating will be explained with examples . First, the case of the n-type layer 4 which is one layer will be explained. The step of heating is performed after forming the n-type layer 4 which is one layer on the layer which mainly contains the cuprous oxide and/or the complex oxide of cuprous oxides.

The case of the n-type layer 4 which is stacked layers will be explained. When the n-type layer 4 which is stacked layers, the continuity of the connection of the conduction band minimum between the p-type light-absorbing layer 3 and the n-type layer 4 is easily improved. When the continuity of the connection of the conduction band minimum between the p-type light-absorbing layer 3 and the n-electrode 5 is improved, the short circuit current density is improved, and it contributes to improving a conversion efficiency. Therefore, the difference between the conduction band minimum of the p-type light-absorbing layer 3 and the conduction band minimum of the n-type layer 4 ([conduction band minimum of p-type light-absorbing layer 3] - [conduction band minimum of n-type layer 4]) is preferably 0.0 eV or more and 0.5 eV or less, and more preferably 0.0 eV or more and 0.4 eV or less.

An example that the n-type layer 4 is two stacked layers and includes the first n-type layer and the second n-type layer will be explained. The first n-type layer is formed on the layer which mainly contains the cuprous oxide and/or the complex oxide of cuprous oxides. A first timing is before forming the second n-type layer and after forming the first n-type layer. The second n-type layer is formed after forming the first n-type layer. A second timing is before forming the n-electrode 5 and after forming the second n-type layer. The step of heating is performed at the first timing and/or the second timing. When the step of heating is performed at the first timing, the Cu phase which is deposited in the vicinity of the interface between the layer which mainly contains the cuprous oxide and/or the complex oxide of cuprous oxides and the first n-electrode is oxidized and can be changed to cuprous oxide. When the step of heating is performed at the second timing, the Cu phase which is deposited in the vicinity of the interface between the layer which mainly contains the cupric oxide and/or the complex oxide of cuprous oxides and the first n-type layer is oxidized and can be changed to cuprous oxide, an element contained in the first n-type layer can be diffused to the second n-type layer, and an element contained in the second n-type layer can be diffused to the first n-type layer. To prevent the diffusion, it is preferable that the step of heating is performed only at the first timing to prevent the diffusion. Even if the Cu phase is formed during forming the second n-type layer, this Cu phase can be oxidized by performing the step of heating at multiple timings. If the step of heating is performed at the first timing and the second timing, the conditions of the two of the steps of heating may be the same or different.

The other example that the n-type layer 4 is stacked layers will be explained. The example that the n-type layer 4 is two stacked layers and includes the first n-type layer and the second n-type layer will be explained. The first n-type layer is Ga₂O₃, and the second n-type layer is ZTO. The first n-type layer is formed on the layer which mainly contains the cuprous oxide and/or the complex oxide of cuprous oxides. A first timing is before forming the second n-type layer and after forming the first n-type layer. The second n-type layer is formed after forming the first n-type layer. A second timing is before forming the n-electrode 5 and after forming the second n-type layer. The step of heating is performed at the first timing and/or the second timing. When the step of heating is performed at the first timing, the Cu phase which is deposited in the vicinity of the interface between the layer which mainly contains the cuprous oxide and/or the complex oxide of cuprous oxides and the first n-electrode is oxidized and can be changed to cuprous oxide. When the step of heating is performed at the second timing, the Cu phase which is deposited in the vicinity of the interface between the layer which mainly contains the cupric oxide and/or the complex oxide of cuprous oxides and the first n-type layer is oxidized and can be changed to cuprous oxide, an element contained in the first n-type layer can be diffused to the second n-type layer, and an element contained in the second n-type layer can be diffused to the first n-type layer. Ga exists in the second n-type layer on the first n-type layer side by diffusing Ga to the second n-type layer, Zn and Sn exist in the first n-type layer on the second n-type layer side by diffusing Zn and Sn to the first n-type layer. Then, the continuity of the connection of the conduction band minimum is improved because the composition of the first n-type layer and the second n-type layer is changed gradiently. The short circuit current density is improved, and it contributes to improving a conversion efficiency because the continuity of the connection of the conduction band minimum is improved. The elements can be diffused under the above heating conditions to improve the continuity of the connection of the conduction band minimum between the p-type light-absorbing layer 3 and the n-type layer 4. When the step of heating is performed at the first timing and the second timing, the conditions of the two of the steps of heating may be the same or different.

When the n-type layer has stacked structure including three or more layers, the step of heating is similarly performed after forming each layer of the n-type layer 4 (during and/or after) but before forming the n-electrode 5.

The n-electrode 5 is formed on the n-type layer 4 by sputtering as a step of forming n-electrode on the n-type layer 4. When an intermediate layer is provided between the n-type layer and the n-electrode 5, the intermediate layer is formed before forming the n-electrode 5. The solar cell 100 which includes the substrate 1, the p-type light-absorbing layer 3 which mainly contains the cuprous oxide and/or the complex oxide of cuprous oxide whose surface is oxidized, the n-type layer 4, and the n-electrode 5 by the above steps.

### (Second embodiment)

A second embodiment relates to a multi-junction solar cell. FIG. 6 illustrates a conceptual sectional diagram of a multi-junction solar cell according to the second embodiment. The multi-junction solar cell 200 of FIG. 6 includes the solar cell (first solar cell) 100 according to the first embodiment on the light incident side and a second solar cell 201. The band gap of the p-type light-absorbing layer of the second solar cell 201 is smaller than the band gap of the light-absorbing layer 3 of the solar cell 100 according to the first embodiment. Incidentally, the multi-junction solar cell according to the embodiment includes a solar cell in which three or more solar cells are jointed.

The band gap of the p-type light-absorbing layer 3 of the first solar cell 100 according to the first embodiment is about 2.0 eV - 2.2 eV, and thus the band gap of the light-absorbing layer of the second solar cell 201 is preferably 1.0 eV or more and 1.6 eV or less. The light-absorbing layer of the second solar cell 201 is preferably selected from the group consisting of any one or more compound semiconductor layers among CIGS-based having a high In content and CdTe-based compound semiconductor layers, crystalline silicon and perovskite type compound.

### (Third embodiment)

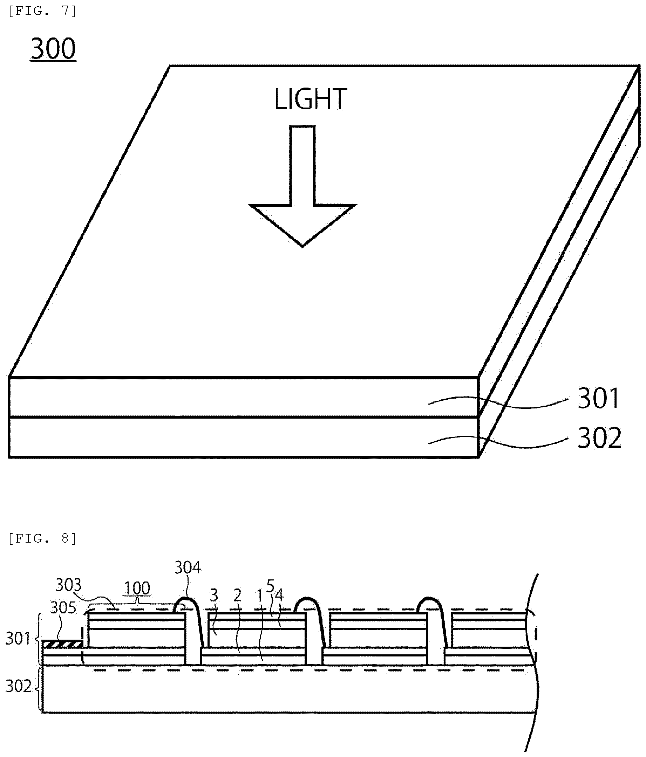

A third embodiment relates to a solar cell module. FIG. 7 illustrates a perspective diagram of a solar cell module 300 according to the third embodiment. The solar cell module 300 in FIG. 7 is a solar cell module in which a first solar cell module 301 and a second solar cell module 302 are stacked one on the other. The first solar cell module 301 is on the light incident side and includes the solar cell 100 according to the first embodiment. It is preferable to use the second solar cell 201 in the second solar cell module 302.

FIG. 8 illustrates a sectional diagram of the solar cell module 300. In FIG. 8, the structure of the first solar cell module 301 is illustrated in detail but the structure of the second solar cell module 302 is not illustrated. In the second solar cell module 302, the structure of the solar cell module is appropriately selected depending on the light-absorbing layer of the solar cell to be used. In the solar cell module 300 in FIG. 8, a plurality of submodules 303 in which a plurality of solar cells 100 are arranged in the horizontal direction and electrically connected to each other by a wiring 304 in series and which is enclosed by a broken line are included and the plurality of submodules 303 are electrically connected to each other in parallel or in series. Adjacent submodules are electrically connected by a busbar 305.

In adjacent solar cells 100, the n-electrode 5 on the upper side and the p-electrode 2 on the lower side are connected by the wiring 304. Both ends of the solar cell 100 in the submodule 303 are connected to the busbar 305, the busbar 305 is preferably configured to electrically connect a plurality of submodules 303 in parallel or in series and adjust the output voltage with the second solar cell module 302. Incidentally, the connection system of the solar cell 100 shown in the third embodiment is an example, the solar cell module can be configured by other connection systems.

### (Fourth embodiment)

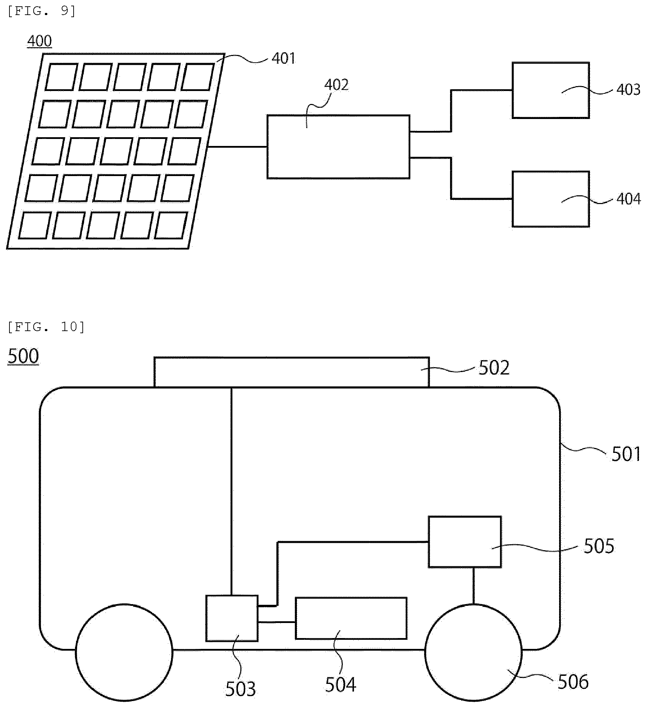

A fourth embodiment relates to a solar photovoltaic power generation system. The solar cell module 300 according to the third embodiment can be used as a generator which generates electric power in the solar photovoltaic power generation system according to the fourth embodiment. The solar photovoltaic power generation system according to the embodiment generates electric power using a solar cell module and specifically includes a solar cell module which generates electric power, a unit which converts the generated electricity into electric power, and a power storage unit which stores the generated electricity or a load which consumes the generated electricity. FIG. 9 illustrates a configuration diagram of a solar photovoltaic power generation system 400 according to the embodiment. The solar photovoltaic power generation system in FIG. 9 includes a solar cell module 401 (300), a converter 402, a storage battery 403, and a load 404. Either of the storage battery 403 or the load 404 may be omitted. The load 404 may be configured to be able to utilize the electric energy stored in the storage battery 403. The converter 402 is an apparatus including a circuit or a device which performs power conversion such as voltage transformation or DC-AC conversion such as a DC-DC converter, DC-AC-converter, AC-AC-converter and the like. As the configuration of the converter 402, a suitable configuration may be adopted depending on the configuration of the generated voltage, the storage battery 403, and the load 404.

The solar cells included in the submodule 300 generate electric power, the electric energy is converted by the converter 402 and stored in the storage battery 403 or consumed by the load 404. It is preferable to provide the solar cell module 401 with a sunlight tracking and driving apparatus for constantly directing the solar cell module 401 toward the sun or a light collector which collects sunlight or to add an apparatus or the like for improving the power generation efficiency.

It is preferable that the solar photovoltaic power generation system 400 is used for immovable property such as dwellings, commercial facilities, and factories or for movable property such as vehicles, aircraft, and electronic devices. The electric power generation amount is expected to increase as the solar cell having an excellent conversion efficiency according to the embodiment is used in the solar cell module 401.

A vehicle is described as an example of utilization of the solar photovoltaic power generation system 400. FIG. 10 illustrates a conceptual configuration diagram of a vehicle 500. The vehicle 500 in FIG. 8 includes a vehicle body 501, a solar cell module 502, a power converter 503, a storage battery 504, a motor 505, and tires (wheels) 506. The electric power generated by the solar cell module 502 provided on the upper portion of the vehicle body 501 is converted by the power converter 503 and is charged in the storage battery 504 or consumed by a load such as the motor 505. The vehicle 500 can be moved by rotating the tires (wheels) 506 by the motor 505 using the electric power supplied from the solar cell module 502 or the storage battery 504. The solar cell module 502 may not be a multi-junction type but may be configured only of such as the first solar cell module including the solar cell 100 according to the first embodiment. In the case of adopting a transparent solar cell module 502, it is also preferable to use the solar cell module 502 as a window for generating electric power on the side surface of the vehicle body 501 in addition to the upper portion of the vehicle body 501.

A flying object (multi-copter) is described as an example of utilization of the solar photovoltaic power generation system 400. The flying object uses a solar cell module 300. A configuration of the flying object according to the present embodiment will be briefly described using a schematic view of a flying object600 (quadcopter) of FIG. 14. The flying object 600 includes a solar cell module 300, a body frame 601, motors 602, rotary wings 603, and a control unit 604. The solar cell module 300, the motors 602, the rotary wings 603, and the control unit 604 are disposed in the body frame 601. The control unit 604 converts power output from the solar cell module 300 and adjusts output. The control unit 604 can further include a storage battery that stores the generated power by the solar cell module 300. The motors 602 rotate the rotary wings 603 using the power output from the solar cell module 300. By using the flying object 600 with the present configuration having the solar cell module 300 according to the embodiment, a flying object that can fly using more electric power is provided.

Hereinafter, the present disclosure will be described more specifically based on Examples, but the present disclosure is not limited to the following Examples.

### (Example 1)

ITO (In : Sn = 80 : 20, film thickness 20 nm) and ATO (Sn : Sb = 98 : 2, film thickness: 150 µm) are deposited on an upper surface of a glass substrate on a side in contact with glass as a p-electrode on a back surface side. A Cu₂O light-absorbing layer is formed on a transparent p-electrode by heating at 500°C by a sputtering method in an oxygen and argon gas atmosphere.

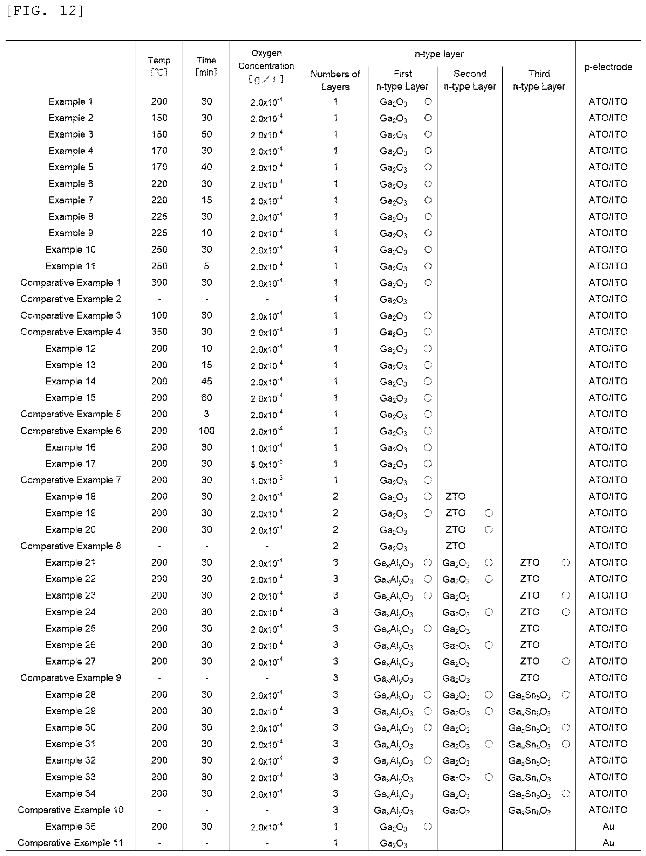

Thereafter, by an ALD method, 10 nm of Ga_{1.80}Al_{0.20}O_{3.00} as a n-type layer is deposited. Thereafter, the n-type layer deposited member is returned to a room temperature, the temperature of the Cu2O light-absorbing layer of the n-type layer deposited member is regulated at 200 °C in an atmosphere whose oxygen concentration is 2.0 x 10⁻⁴ [g/L] . The temperature of the Cu2O light-absorbing layer of the n-type layer deposited is regarded as 200 °C when the temperature of the hotplate becomes 200°C. In this state, the n-type deposited member is performed for 30 minutes. Thereafter, a transparent conductive film of AZO as the n-electrode is deposited on the n-type layer. A solar cell is obtained by forming an MgF₂ film as an antireflection film. The obtained solar cell is evaluated for a short circuit current (Jsc), an open circuit voltage (Voc), a fill factor (FF), conversion efficiency, and transmittance. FIG. 12 illustrates the n-type layer, the performing temperature of the step of the heating, (Temp [°C]), performing duration (Time [min]), and the oxygen concentration ([g/L]). When the n-type layer is one layer, the composition is shown in the column of the first n-type layer. The step of heating is performed in the examples with a circle in the right-side column of the composition of the n-type layer after forming the n-type layer having the composition. Incidentally, since ozone and vapor water are not introduced in the chamber in the step of the heating, the ozone concentration and the water vapor concentration are 5.0 x 10⁻⁸ [g/L] or less.

### (Examples 2 to 34, Comparative examples 1 to 10)

The solar cells of Example 2 to 34 and Comparative Examples 1 to 10 are manufactured under the conditions as same as Example 1 except for the conditions of forming and heating the n-type layers shown in FIG. 12. The obtained solar cell is evaluated for a short circuit current (Jsc), an open circuit voltage (Voc), a fill factor (FF), conversion efficiency, and transmittance . In the table of FIG. 12, the step of heating is not performed where the column of the temperature and the like is represented with "-".

### (Example 35, Comparative Example 11)

The Cu₂O light-absorbing layer is obtained by heating a Cu plate in an oxidizing atmosphere. 10 nm of Ga_{2.0}O_{3.0} as the n-type layer is deposited on the Cu₂O light-absorbing layer, and the step of heating is performed. After forming n-electrode, Au electrode film is formed on the Cu₂O light-absorbing layer on a surface opposite to the n-type layer. The solar cell is manufactured under the conditions as same as Example 1 except for them. The obtained solar cell is evaluated for a short circuit current (Jsc), an open circuit voltage (Voc), a fill factor (FF), conversion efficiency, and transmittance.

The amount of light is adjusted to 1 sun by using a solar simulator simulating a light source of AM 1.5G and using a reference Si cell under a light source. A temperature in a measurement room is 25°C under an atmospheric pressure. A voltage is swept and a current density (current divided by a cell area) is measured. When a horizontal axis represents the voltage and a vertical axis represents the current density, a point intersecting the horizontal axis represents an open circuit voltage Voc, and a point intersecting the vertical axis represents a short circuit current density Jsc. When the voltage and the current density are multiplied on a measurement curve and maximum points are Vmpp and Jmpp (maximum power point), respectively, FF = (Vmpp * Jmpp) / (Voc * Jsc), and a conversion efficiency Eff. is obtained by Eff. = Voc * Jsc * FF. After the measurement, it is cleaved, and the intensity profile of the first region and the second region of the HAADF-STEM image is obtained.

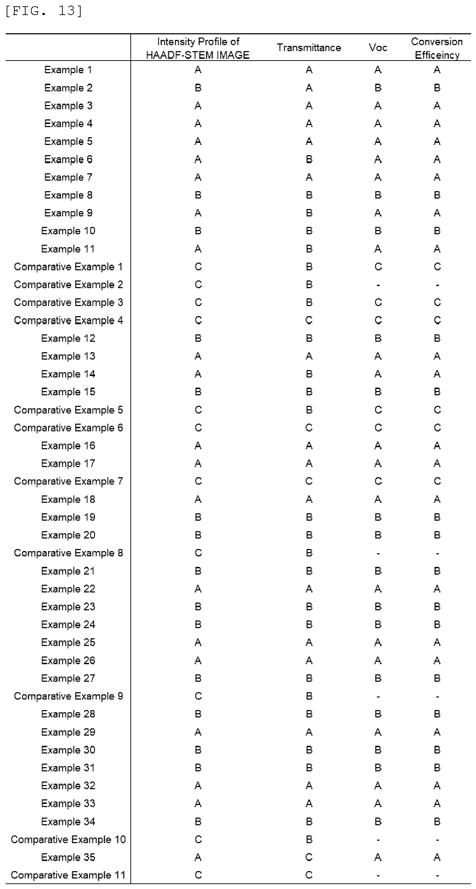

In the tables of FIG. 13 related to examples, the evaluation of the intensity profile of the HAADF-STEM image of examples and comparative examples is shown together with the short-circuit current (Jsc), the open circuit voltage (Voc), the conversion efficiency, and the transmittance.

The intensity profile of the HAADF-STEM image is evaluated as A when a maximum intensity of an intensity profile of a HAADF-STEM image of the first region is 97 % or more and 103 % or less of a maximum intensity of an intensity profile of a HAADF-STEM of the second region, is evaluated as B when a maximum intensity of an intensity profile of a HAADF-STEM image of the first region is more than 103 % and less than 105 % of a maximum intensity of an intensity profile of a HAADF-STEM of the second region or more than 95 % and less than 97 % of a maximum intensity of an intensity profile of a HAADF-STEM of the second region, and is evaluated as C when a maximum intensity of an intensity profile of a HAADF-STEM image of the first region is 105 % or more or 95 % or less of a maximum intensity of an intensity profile of a HAADF-STEM of the second region.

The transmittance is evaluated as A when the transmittance of light in a wavelength band of 700 nm or more and 1200 nm or less is 70 % or more, is evaluated as B when the transmittance of light in a wavelength band of 700 nm or more and 1200 nm or less is 60 % or more and less than 70%, and is evaluated as C when the transmittance of light in a wavelength band of 700 nm or more and 1200 nm or less is less than 60 %.

FF is evaluated as A when FF is 1.1 times or more the conversion efficiency of Comparative Example 2, is evaluated as B when FF is 1.0 times or more and less than 1.1 times FF of Comparative Example 2, and is evaluated as C when FF is less than 1.0 times FF of Comparative Example 2.

The conversion efficiency is evaluated as A when the conversion efficiency is 1.1 times or more the conversion efficiency of Comparative Example 2, is evaluated as B when the conversion efficiency is 1.0 times or more and less than 1.1 times the conversion efficiency of Comparative Example 2, and is evaluated as C when the conversion efficiency is less than 1.0 times the conversion efficiency of Comparative Example 2.

For the evaluation of Voc and the conversion efficiency, Comparative Example 2 is the comparator for Examples 1 to 17 and Comparative Example 1 and 3 to 10. For the evaluation of Voc and the conversion efficiency, Comparative Example 8 is the comparator for Examples 18 to 20. For the evaluation of Voc and the conversion efficiency, Comparative Example 9 is the comparator for Examples 21 to 27. For the evaluation of Voc and the conversion efficiency, Comparative Example 10 is the comparator for Examples 28 to 34 . For the evaluation of Voc and the conversion efficiency, Comparative Example 11 is the comparator for Example 35. The evaluation is performed after the contrast correction of the intensity profile of the HAADF -STEM image so that a low intensity (intensity of the n-type layer on the n-electrode side) and a high intensity (average intensity of the second region of the p-type light-absorbing layer) of comparative example of the comparator are approximately the same.

As can be seen tables of FIG. 12 and 13, the intensity profile of the HAADF-STEM image is improved because the Cu phase deposited in the vicinity of the interface between the layer which mainly contains the cuprous oxide and/or the complex oxide of cuprous oxides is oxidized and can be changed to cuprous oxide under the appropriate heating conditions in the atmosphere of the appropriate oxygen concentration. Since the Cu phase deposited in the vicinity of the interface between the layer which mainly contains the cuprous oxide and/or the complex oxide of cuprous oxides and the first n-type layer is oxidized and changed to cuprous oxide, the carrier re-combination at the interface is decreased, Voc is increased, and the conversion efficiency is improved accordingly. When Cu phase exist and the transmittance is decreased, the Cu phase deposited in the vicinity of the interface between the layer which mainly contains the cuprous oxide and/or the complex oxide of cuprous oxides and the first n-type layer is oxidized and changed to cuprous oxide, and the transmittance is improved. The heating is performed under the extreme conditions, cupric oxide is formed, transmittance is decreased, and Voc and the conversion efficiency is decreased accordingly. The conversion efficiency of the multi-junction solar cell having the solar cell of examples for top cell and a solar cell having Si as a light-absorbing layer for top cell is improved likewise. In the specification, some elements are represented only by chemical symbols for elements.
Hereinafter, clauses of embodiments are additionally noted.

### Clause 1

A solar cell comprising:
a p-electrode;
a p-type light-absorbing layer containing a cuprous oxide and/or a complex oxide of cuprous oxides on the p-electrode;
an n-type layer on the p-type light-absorbing layer; and
an n-electrode, wherein
when a first region is a region of the p-type light-absorbing layer from an interface between the p-type light absorbing layer to a depth of 10 nm toward the p-electrode, and a second region is a region of the p-type light-absorbing layer from the interface between the p-type light absorbing layer and the n-type layer to a depth of 100 nm toward the p-electrode excluding the first region, a maximum intensity of an intensity profile of a HAADF-STEM image of the first region is 95 % or more and 105% or less of an average intensity of an intensity profile of a HAADF-STEM of the second region.

### Clause 2

The solar cell according to clause 1, wherein the n-type layer contains an oxide or a sulfide.

### Clause 3

The solar cell according to clause 1 or 2, wherein the n-type layer contains the oxide or the sulfide which contains at least one or more elements selected from the group consisting of Ga, Al, B, In, Ti, Zn, Hf, Zr, Cd, Sn, Si and Ge.

### Clause 4

The solar cell according to any one of clauses 1 to 3, wherein the n-type layer includes one layer or stacked layers of the oxide or one layer or stacked layers of the sulfide.

### Clause 5

The solar cell according to any one of clauses 1 to 4, wherein an average intensity of the intensity profile of the HAADF-STEM image of the first region is 85 % or more and 95% or less of the average intensity of the intensity profile of the HAADF-STEM of the second region.

### Clause 6

The solar cell according to any one of clauses 1 to 5, wherein an minimum intensity of the intensity profile of the HAADF-STEM image in a region of the first region from a depth of 5 nm from the interface of the p-type light-absorbing layer and the n-type layer toward the p-electrode to a depth of 10 nm is 87 % or more and 93 % or less of the average intensity of the average intensity of the intensity profile of the HAADF-STEM image of the second region.

### Clause 7

The solar cell according to any one of clauses 1 to 6, wherein a minimum intensity of the intensity profile of the HAADF-STEM image of the first region is 78 % or more and 85 % or less of the average intensity of the intensity profile of the HAADF-STEM of the second region.

### Clause 8

The solar cell according to any one of clauses 1 to 7, wherein the average intensity of the intensity profile of the HAADF-STEM image of the first region is 85 % or more and 95 % or less of a maximum intensity of the intensity profile of the HAADF-STEM of the first region and 110 % or more and 120 % or less of a minimum intensity of the intensity profile of the HAADF-STEM of the first region.

### Clause 9

The solar cell according to any one of clauses 1 to 8, wherein the average intensity of the intensity profile of the HAADF-STEM image of the second region is 90 % or more and 99 % or less of a maximum intensity of the intensity profile of the HAADF-STEM of the second region and 101 % or more and 110 % or less of a minimum intensity of the intensity profile of the HAADF-STEM of the second region.

### Clause 10

A method for manufacturing a solar cell comprising;
a step of forming a n-type layer on the layer which mainly contains cuprous oxide and/or a complex oxide of cuprous oxides;
a step of forming a n-electrode on the n-type layer; and
a step of heating a member that the n-type layer is formed after forming the n-type layer but before forming the n-electrode or during forming the n-type layer.

### Clause 11

The method for the manufacturing the solar cell according to clause 10, wherein the step of the heating is performed in a non-oxidizing atmosphere.

### Clause 12

The method for the manufacturing the solar cell according to clause 10 or 11, wherein a temperature of the layer which mainly contains the cuprous oxide and/or the complex oxide of cuprous oxides in the step of heating is 150 °C or higher and 250 °C or lower.

### Clause 13

The method for the manufacturing the solar cell according to any one of clauses 11 to 13, wherein the temperature of the layer which mainly contains the cuprous oxide and/or the complex oxide of cuprous oxides in the step of heating is 160 °C or higher and 230 °C or lower.

### Clause 14

The method for the manufacturing the solar cell according to any one of clauses 11 to 14, wherein the temperature of the layer which mainly contains the cuprous oxide and/or the complex oxide of cuprous oxides in the step of heating is 170 °C or higher and 220 °C or lower.

### Clause 15

The method for the manufacturing the solar cell according to any one of clauses 11 to 15, wherein a duration of the step of heating is 5 minutes or more and 60 minutes or less.

### Clause 16

The method for the manufacturing the solar cell according to any one of clauses 11 to 16, wherein an oxygen concentration of the step of heating is 5.0 × 10⁻⁸ [g/L] or more and 8.0 × 10⁻⁴ [g/L] or less.

### Clause 17

The method for the manufacturing the solar cell according to any one of clauses 11 to 17, wherein an ozone concentration of the step of heating is 1/10 or less of an oxygen concentration.

### Clause 18

The method for the manufacturing the solar cell according to any one of clauses 11 to 18, wherein a water vapor concentration of the atmosphere in the step of heating is 5.0 x 10⁻⁸ [g/L] or more and 8.0 x 10⁻⁴ [g/L] or less .

### Clause 19

The method for the manufacturing the solar cell according to any one of clauses 11 to 19, wherein a total pressure of an atmosphere of the step of the heating is 100 Pa or more and 200,000 Pa or less.

### Clause 20

A multi-junction solar cell comprising:
the solar cell according to any one of clauses 1 to 10; and
a solar cell including a light-absorbing layer in which a band gap is smaller than a band gap of the p-type light-absorbing layer of the solar cell according to any one of clauses 1 to 10.

### Clause 21

A solar cell module using the solar cell according to any one of clauses 1 to 15.

### Clause 22

A photovoltaic power generation system that performs photovoltaic power generation by using the solar cell module according to clause 21.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions .

### [Reference Signs List]

100, 101... Solar cell (first solar cell), 1... Substrate, 2...p-electrode,
3... Light-absorbing layer, 4...n-type layer, 5...n-electrode,
200...Multijunction solar cell, 201...Second solar cell,
300...Solar cell module, 301...First solar cell module, 302...Second solar cell module, 303...Submodules, 304...Wiring, 305...Busbar
400...Solar power generation system, 401...Solar cell module,
402...Converter, 403...Storage battery, 404...Load
500...Vehicle, 501...Car body, 502...Solar cell module, 503...Electric power conversion device, 504...Storage battery, 505...Motor, 506...Tire (wheel)
600...Flying object, 601...Body flame, 602...Motor, 603...Rotary wing,
604...Control Unit

## Claims

1. A solar cell comprising:
a p-electrode;
a p-type light-absorbing layer containing a cuprous oxide and/or a complex oxide of cuprous oxides on the p-electrode;
an n-type layer on the p-type light-absorbing layer; and
an n-electrode, wherein
when a first region is a region of the p-type light-absorbing layer from an interface between the p-type light absorbing layer to a depth of 10 nm toward the p-electrode, and a second region is a region of the p-type light-absorbing layer from the interface between the p-type light absorbing layer and the n-type layer to a depth of 100 nm toward the p-electrode excluding the first region, a maximum intensity of an intensity profile of a HAADF-STEM image of the first region is 95 % or more and 105% or less of an average intensity of an intensity profile of a HAADF-STEM of the second region.

2. The solar cell according to claim 1, wherein the n-type layer contains an oxide or a sulfide.

3. The solar cell according to claim 1 or 2, wherein the n-type layer contains the oxide or the sulfide which contains at least one or more elements selected from the group consisting of Ga, Al, B, In, Ti, Zn, Hf, Zr, Cd, Sn, Si and Ge.

4. The solar cell according to any one of claims 1 to 3, wherein the n-type layer includes one layer or stacked layers of the oxide or one layer or stacked layers of the sulfide.

5. The solar cell according to any one of claims 1 to 4, wherein an average intensity of the intensity profile of the HAADF-STEM image of the first region is 85 % or more and 95% or less of the average intensity of the intensity profile of the HAADF-STEM of the second region.

6. The solar cell according to any one of claims 1 to 5, wherein an minimum intensity of the intensity profile of the HAADF-STEM image in a region of the first region from a depth of 5 nm from the interface of the p-type light-absorbing layer and the n-type layer toward the p-electrode to a depth of 10 nm is 87 % or more and 93 % or less of the average intensity of the average intensity of the intensity profile of the HAADF-STEM image of the second region.

7. The solar cell according to any one of claims 1 to 6, wherein a minimum intensity of the intensity profile of the HAADF-STEM image of the first region is 78 % or more and 85 % or less of the average intensity of the intensity profile of the HAADF-STEM of the second region.

8. The solar cell according to any one of claims 1 to 7, wherein the average intensity of the intensity profile of the HAADF-STEM image of the first region is 85 % or more and 95 % or less of a maximum intensity of the intensity profile of the HAADF-STEM of the first region and 110 % or more and 120 % or less of a minimum intensity of the intensity profile of the HAADF-STEM of the first region.

9. The solar cell according to any one of claims 1 to 8, wherein the average intensity of the intensity profile of the HAADF-STEM image of the second region is 90 % or more and 99 % or less of a maximum intensity of the intensity profile of the HAADF-STEM of the second region and 101 % or more and 110 % or less of a minimum intensity of the intensity profile of the HAADF-STEM of the second region.

10. A method for manufacturing a solar cell comprising;
a step of forming a n-type layer on the layer which mainly contains cuprous oxide and/or a complex oxide of cuprous oxides;
a step of forming a n-electrode on the n-type layer; and
a step of heating a member that the n-type layer is formed after forming the n-type layer but before forming the n-electrode or during forming the n-type layer.

11. The method for the manufacturing the solar cell according to claim 10, wherein the step of the heating is performed in a non-oxidizing atmosphere.

12. The method for the manufacturing the solar cell according to claim 10 or 11, wherein a temperature of the layer which mainly contains the cuprous oxide and/or the complex oxide of cuprous oxides in the step of heating is 150 °C or higher and 250 °C or lower.

13. The method for the manufacturing the solar cell according to any one of claims 11 to 13, wherein the temperature of the layer which mainly contains the cuprous oxide and/or the complex oxide of cuprous oxides in the step of heating is 160 °C or higher and 230 °C or lower.

14. The method for the manufacturing the solar cell according to any one of claims 11 to 14, wherein the temperature of the layer which mainly contains the cuprous oxide and/or the complex oxide of cuprous oxides in the step of heating is 170 °C or higher and 220 °C or lower.

15. The method for the manufacturing the solar cell according to any one of claims 11 to 15, wherein a duration of the step of heating is 5 minutes or more and 60 minutes or less.

16. The method for the manufacturing the solar cell according to any one of claims 11 to 16, wherein an oxygen concentration of the step of heating is 5.0 × 10⁻⁸ [g/L] or more and 8.0 × 10⁻⁴[g/L] or less.

17. The method for the manufacturing the solar cell according to any one of claims 11 to 17, wherein an ozone concentration of the step of heating is 1/10 or less of an oxygen concentration.

18. The method for the manufacturing the solar cell according to any one of claims 11 to 18, wherein a water vapor concentration of the atmosphere in the step of heating is 5.0 x 10⁻⁸ [g/L] or more and 8.0 x 10⁻⁴ [g/L] or less.

19. The method for the manufacturing the solar cell according to any one of claims 11 to 19, wherein a total pressure of an atmosphere of the step of the heating is 100 Pa or more and 200,000 Pa or less.

20. A multi-junction solar cell comprising:
the solar cell according to any one of claims 1 to 10; and
a solar cell including a light-absorbing layer in which a band gap is smaller than a band gap of the p-type light-absorbing layer of the solar cell according to any one of claims 1 to 10.

21. A solar cell module using the solar cell according to any one of claims 1 to 15.

22. A photovoltaic power generation system that performs photovoltaic power generation by using the solar cell module according to claim 21.
